# EUROPEAN PATENT APPLICATION

(11) **EP 4 823 266 A1**
(43) Date of publication of application: **14.10.2026**
(21) Application number: 25225838.9
(22) Date of filing: 19.12.2025
(51) Int. Cl.: H05K 9/00

(54) **WOVEN MULTI-MATERIAL SHIELD FOR AN ELECTRIC CABLE**

(30) Priority: 20.12.2024 US 202418990044
(71) Applicant: RTX Corporation, Farmington, CT 06032 (US)
(72) Inventor: CHOE, Jung Muk, Glastonbury, 06033 (US); YEE, James, Norwich, 06360 (US)
(74) Representative: Dehns

(57) **Abstract**

An apparatus is provided that includes a first electric device (128), a second electric device (130), an electric cable (122) and a cable shield (124). The electric cable (122) electrically couples the first electric device (128) to the second electric device (130). The cable shield (124) includes a first metal and a second metal. The first metal has a first permeability and a first impedance. The second metal has a second permeability and a second impedance. The first permeability is greater than the second permeability. The first impedance is greater than the second impedance. The electric cable (122) projects longitudinally, through a bore (126) of the cable shield (124) and along the first metal and the second metal, between the first electric device (128) and the second electric device (130).

## Description

### BACKGROUND OF THE DISCLOSURE

### 1. Technical Field

This disclosure relates generally to an electric cable and, more particularly, to shielding electromagnetic interference (EMI) generated by the electric cable.

### 2. Background Information

An aircraft may include various electric cables. During operation of the aircraft, electricity conducted through the electric cables may generate and radiate electromagnetic interference. Various techniques are known in the art for shielding such electromagnetic interference. While these known electromagnetic interference shielding techniques have various benefits, there is still room in the art for improvement.

### SUMMARY OF THE DISCLOSURE

According to an aspect of the present disclosure, an apparatus is provided that includes a first electric device, a second electric device, an electric cable and a cable shield. The electric cable electrically couples the first electric device to the second electric device. The cable shield includes a first metal and a second metal. The first metal has a first permeability and a first impedance. The second metal has a second permeability and a second impedance. The first permeability is greater than the second permeability. The first impedance is greater than the second impedance. The electric cable projects longitudinally, through a bore of the cable shield and along the first metal and the second metal, between the first electric device and the second electric device.

According to another aspect of the present disclosure, another apparatus is provided that includes a first electric device, a second electric device, an electric cable and a braided cable sleeve. The electric cable electrically couples the first electric device to the second electric device. The braided cable sleeve is constructed from a plurality of filaments of a magnetic metal and a plurality of filaments a non-magnetic metal. The electric cable projects longitudinally, through a bore of the braided cable sleeve and along the plurality of filaments of the magnetic metal and the plurality of filaments of the non-magnetic metal, between the first electric device and the second electric device.

According to still another aspect of the present disclosure, another apparatus is provided that includes a plurality of filaments woven together to form a braided cable sleeve with a bore which extends longitudinally through the braided cable sleeve and along each of the filaments. The filaments include a plurality of magnetic metal filaments and a plurality of non-magnetic metal filaments. The magnetic metal filaments are configured to provide electromagnetic interference shielding for an electrical cable to be run longitudinally through the bore. The non-magnetic metal filaments are configured to facilitate electrical grounding of the braided cable sleeve.

The following optional features may be applied to any of the above aspects.

Each of the magnetic metal filaments may be formed from or otherwise include at least one of nickel, cobalt or iron. Each of the non-magnetic metal filaments may be formed from or otherwise include at least one of copper or aluminum.

The magnetic metal may be or otherwise include at least one of nickel, cobalt or iron. The non-magnetic metal may be or otherwise include at least one of copper or aluminum.

The first metal may be interwoven with the second metal longitudinally along the cable shield.

The cable shield may be configured as or otherwise include a braided cable sleeve constructed from a plurality of filaments of the first metal and a plurality of filaments of the second metal.

The cable shield may include a multi-filament set. The multi-filament set may include a first filament of the first metal and a second filament of the second metal that is laterally next to and extending parallel with the first filament of the first metal.

The cable shield may include a first filament of the first metal and a second filament of the second metal crossing the first filament of the first metal.

The cable shield may include a first filament of the first metal and a second filament of the second metal that is angularly offset from the first filament of the first metal by an offset angle equal to or less the ninety degrees.

The first metal may be a mu-metal.

The first metal may be or otherwise include at least one of nickel, cobalt or iron.

The first metal may be or otherwise include a magnetic metal.

The second metal may be or otherwise include at least one of copper or aluminum.

The second metal may be or otherwise include a non-magnetic metal.

The cable shield may be electrically grounded with at least one of the first electric device or the second electric device.

The apparatus may also include insulation between the electric cable and the cable shield.

The apparatus may also include a second electric cable electrically coupling the first electric device to the second electric device. The second electric cable may project longitudinally, through the bore of the cable shield and along the first metal and the second metal, between the first electric device and the second electric device.

The apparatus may include a second electric cable and a second cable shield. The second electric cable may electrically couple the first electric device to the second electric device. The second cable shield may include the first metal and the second metal. The second electric cable may project longitudinally, through a bore of the second cable shield and along the first metal and the second metal, between the first electric device and the second electric device.

The first electric device may be configured as or otherwise include an electric machine configurable as at least one of an electric motor or an electric generator. The second electric device may be configured as or otherwise include an electric machine controller for the electric machine.

The apparatus may also include a rotating structure for an aircraft propulsion system. The rotating structure may be operatively coupled to the electric machine.

The apparatus may also include an electric machine configurable as at least one of an electric motor or an electric generator. The first electric device may be configured as or otherwise include an electric machine controller for the electric machine. The second electric device may be part of an electrical system for at least one of providing electrical power to or receiving electrical power from the electric machine controller.

The present disclosure may include any one or more of the individual features disclosed above and/or below alone or in any combination thereof.

The foregoing features and the operation of the invention will become more apparent in light of the following description and the accompanying drawings.

### BRIEF DESCRIPTION OF THE DRAWINGS

FIG. 1 is a partial schematic illustration of an aircraft propulsion system.
FIG. 2 is a schematic illustration of a portion of the aircraft propulsion system at an electric machine system.
FIG. 3 is a partial schematic sectional illustration of a shielded electric cable electrically coupling electric devices together.
FIG. 4 is a partial cutaway perspective illustration of the shielded electric cable.
FIGS. 5A-C are partial illustrations of exemplary weave patterns for a woven cable shield.
FIGS. 6A and 6B are partial illustrations of an exemplary elongated member of the woven cable shield with various filament arrangements.
FIGS. 7-9 are partial schematic sectional illustrations of various alternative shielded electric cable arrangements.

### DETAILED DESCRIPTION

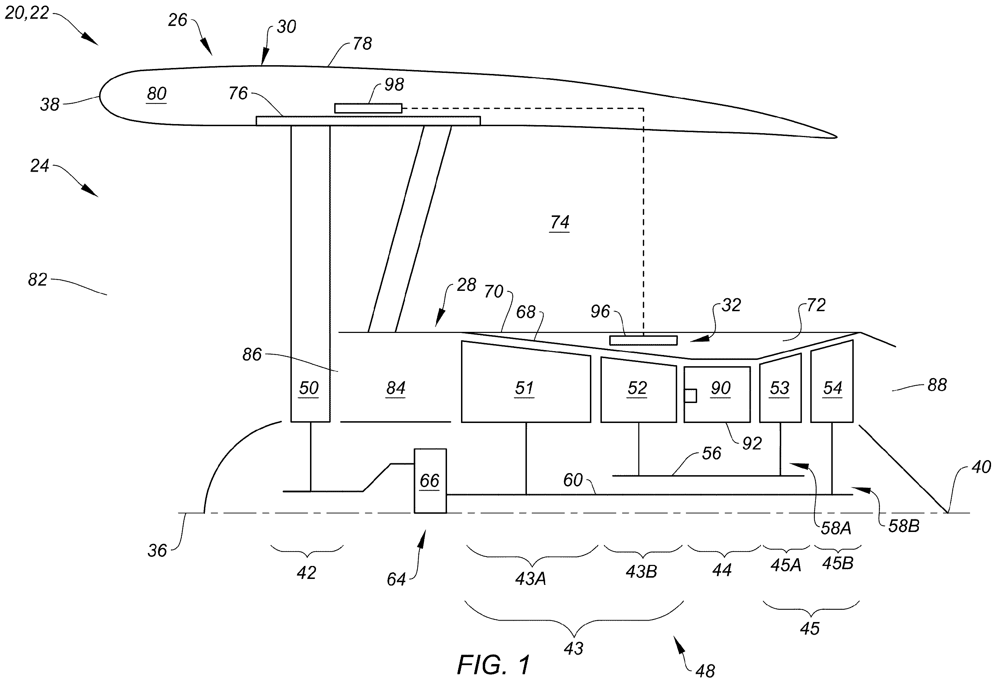

FIG. 1 illustrates a powerplant 20 for an aircraft. The aircraft may be an airplane, a rotorcraft (e.g., a helicopter), a drone (e.g., an unmanned aerial vehicle (UAV)) or any other manned or unmanned aerial vehicle or system. For ease of description, the aircraft powerplant 20 is described below as a propulsion system 22 for the aircraft and, more particularly, as a turbofan propulsion system. The aircraft powerplant 20 of the present disclosure, however, is not limited to such an exemplary propulsion system. The aircraft propulsion system 22, for example, may alternatively be configured as a turbojet propulsion system, a turboprop propulsion system, a turboshaft propulsion system, a propfan propulsion system, a pusher fan propulsion system, or any other type of ducted or open rotor propulsion system. Moreover, the aircraft powerplant 20 is not limited to propulsion system applications. The aircraft powerplant 20, for example, may alternatively (or also) be configured as an electrical power system for the aircraft; e.g., an auxiliary power unit (APU).

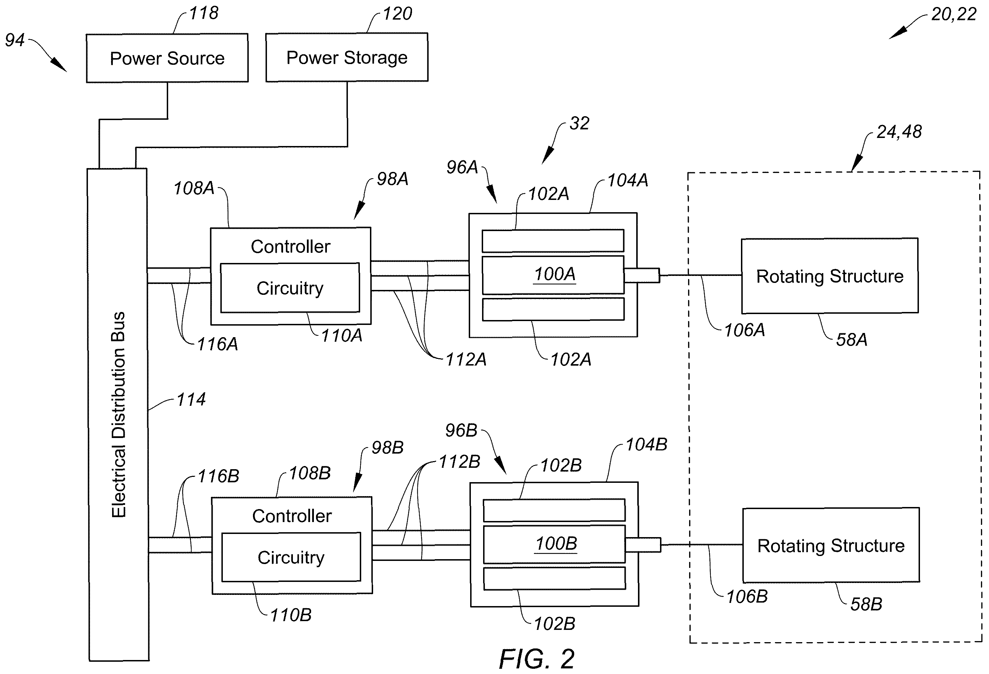

The aircraft propulsion system 22 includes a gas turbine engine 24 (e.g., a turbofan engine) housed within a stationary propulsion system housing 26, which propulsion system housing 26 of FIG. 1 includes an inner housing structure 28 and an outer housing structure 30. The aircraft propulsion system 22 also includes an electric machine system 32; see also FIG. 2. The aircraft propulsion system 22 extends axially along an axis 36 between an axial forward, upstream end 38 of the aircraft propulsion system 22 and an axial aft, downstream end 40 of the aircraft propulsion system 22. Briefly, the propulsion system axis 36 may be a centerline axis of the aircraft propulsion system 22, the turbine engine 24 and/or one or more of its members. The propulsion system axis 36 may also or alternatively be a rotational axis for one or more members of the turbine engine 24.

The aircraft propulsion system 22 and its turbine engine 24 of FIG. 1 include a propulsor section 42 (e.g., a fan section), a compressor section 43, a combustor section 44 and a turbine section 45. The compressor section 43 of FIG. 1 includes a low pressure compressor (LPC) section 43A and a high pressure compressor (HPC) section 43B. The turbine section 45 of FIG. 1 includes a high pressure turbine (HPT) section 45A and a low pressure turbine (LPT) section 45B. Here, at least (or only) the LPC section 43A, the HPC section 43B, the combustor section 44, the HPT section 45A and the LPT section 45B collectively form a core 48 of the turbine engine 24.

The engine sections 42-45B may be arranged sequentially along the propulsion system axis 36 within the propulsion system housing 26. The propulsor section 42 includes a bladed propulsor rotor 50; e.g., a fan rotor. The LPC section 43A includes a bladed low pressure compressor (LPC) rotor 51. The HPC section 43B includes a bladed high pressure compressor (HPC) rotor 52. The HPT section 45A includes a bladed high pressure turbine (HPT) rotor 53. The LPT section 45B includes a bladed low pressure turbine (LPT) rotor 54.

The HPC rotor 52 is coupled to and rotatable with the HPT rotor 53. The HPC rotor 52 of FIG. 1, for example, is connected to the HPT rotor 53 through a high speed shaft 56. At least (or only) the HPC rotor 52, the HPT rotor 53 and the high speed shaft 56 collectively form a high speed rotating structure 58A; e.g., a high speed spool of the engine core 48. This high speed rotating structure 58A of FIG. 1 and its members 52, 53 and 56 are rotatable about the propulsion system axis 36. However, it is contemplated the high speed rotating structure 58A may alternatively be rotatable about another axis radially and/or angularly offset from the rotational axis of the propulsor rotor 50 and/or the centerline axis of the turbine engine 24.

The LPC rotor 51 is coupled to and rotatable with the LPT rotor 54. The LPC rotor 51 of FIG. 1, for example, is connected to the LPT rotor 54 through a low speed shaft 60. At least (or only) the LPC rotor 51, the LPT rotor 54 and the low speed shaft 60 collectively form a low speed rotating structure 58B; e.g., a low speed spool of the engine core 48. This low speed rotating structure 58B is further coupled to the propulsor rotor 50 through a drivetrain 64. The drivetrain 64 may be configured as a geared drivetrain, where a geartrain 66 (e.g., a transmission, a speed change device, an epicyclic geartrain, etc.) is disposed between and operatively couples the propulsor rotor 50 to the low speed rotating structure 58B and its LPT rotor 54. With this arrangement, the propulsor rotor 50 may rotate at a different (e.g., slower) rotational speed than the low speed rotating structure 58B and its LPT rotor 54. Alternatively, the drivetrain 64 may be configured as a direct drive drivetrain, where the geartrain 66 is omitted. With such an arrangement, the propulsor rotor 50 rotates at a common (the same) rotational speed as the low speed rotating structure 58B and its LPT rotor 54. The low speed rotating structure 58B of FIG. 1 and its members 51, 54 and 60 as well as the propulsor rotor 50 are rotatable about the propulsion system axis 36. However, it is contemplated the low speed rotating structure 58B may alternatively be rotatable about another axis radially and/or angularly offset from the rotational axis of the propulsor rotor 50 and/or the centerline axis of the turbine engine 24.

The inner housing structure 28 of FIG. 1 includes an inner case 68 (e.g., a core case) for the turbine engine 24, an inner nacelle structure 70 (sometimes referred to as an inner fixed structure (IFS)) and an internal inner housing compartment 72. The inner case 68 is disposed radially outboard of, extends axially along and may circumscribe one or more or all of the engine sections 43A-45B and their respective engine rotors 51-54. The inner case 68 may thereby house and provide a support structure for the respective engine sections 43A-45B and their respective engine rotors 51-54. The inner nacelle structure 70 is configured to provide an aerodynamic cover over the engine core 48 and its inner case 68. The inner housing compartment 72 of FIG. 1 is formed by and is disposed radially between the inner case 68 and an inner barrel of the inner nacelle structure 70. The inner housing structure 28 and its inner nacelle structure 70 may also form a radial inner peripheral boundary of a (e.g., annular) bypass flowpath 74 within the aircraft propulsion system 22.

The outer housing structure 30 of FIG. 1 includes an outer case 76 (e.g., a fan case) for the turbine engine 24, an outer nacelle structure 78 and an internal outer housing compartment 80. The outer case 76 is disposed radially outboard of, extends axially along and may circumscribe the propulsor section 42 and its propulsor rotor 50. The outer case 76 may thereby house and provide a containment structure for the propulsor section 42 and its propulsor rotor 50. The outer nacelle structure 78 is configured to provide an aerodynamic cover over the outer case 76. The outer housing compartment 80 of FIG. 1 is at least partially formed by and disposed radially between the outer case 76 and an outer portion (e.g., fan cowls) of the outer nacelle structure 78. The outer housing structure 30 and its outer nacelle structure 78 may also form a radial outer peripheral boundary of the bypass flowpath 74.

During operation, ambient air from outside of the aircraft enters the aircraft propulsion system 22 and its turbine engine 24 through an airflow inlet 82. This air is directed across the propulsor section 42 and into a (e.g., annular) core flowpath 84 and the bypass flowpath 74. The core flowpath 84 of FIG. 1 extends sequentially through the LPC section 43A, the HPC section 43B, the combustor section 44, the HPT section 45A and the LPT section 45B from an airflow inlet 86 into the core flowpath 84 to a combustion products exhaust 88 out from the core flowpath 84 and the engine core 48. The air entering the core flowpath 84 may be referred to as "core air". The bypass flowpath 74 extends through a bypass duct, which bypass flowpath 74 and bypass duct bypass (e.g., are disposed radially outboard of and extend along) the engine core 48 and the inner housing structure 28. The air within the bypass flowpath 74 may be referred to as "bypass air".

The core air is compressed by the LPC rotor 51 and the HPC rotor 52 and is directed into a (e.g., annular) combustion chamber 90 of a (e.g., annular) combustor 92 in the combustor section 44. Fuel is injected into the combustion chamber 90 by one or more fuel injectors and mixed with the compressed core air to provide a fuel-air mixture. This fuel-air mixture is ignited and combustion products thereof flow through and sequentially drive rotation of the HPT rotor 53 and the LPT rotor 54 about the propulsion system axis 36. The rotation of the HPT rotor 53 and the LPT rotor 54 respectively drive rotation of the HPC rotor 52 and the LPC rotor 51 about the propulsion system axis 36 and, thus, compression of the air received from the core inlet 86. The rotation of the LPT rotor 54 also drives rotation of the propulsor rotor 50. The rotation of the propulsor rotor 50 propels the bypass air through and out of the bypass flowpath 74. The propulsion of the bypass air may account for a majority of thrust generated by the turbine engine 24 of FIG. 1.

Referring to FIG. 2, the electric machine system 32 is electrically coupled to an electrical system 94 for the aircraft. The electric machine system 32 of FIG. 2 includes one or more electric machines 96A and 96B (generally referred to as "96") and one or more electric machine (EM) controllers 98A and 98B (generally referred to as "98"). For ease of description, each electric machine 96 of FIG. 2 is described below as being electrically coupled to, controlled by and/or otherwise associated with a single, dedicated one of the EM controllers 98. However, it is contemplated a single EM controller may alternatively be electrically coupled to, may control and/or may otherwise be associated with multiple electric machines. It is also contemplated multiple EM controllers may be electrically coupled to, may control and/or may otherwise be associated with one or more common electric machines.

Each electric machine 96A, 96B of FIG. 2 includes an electric machine rotor 100A, 100B (generally referred to as "100"), an electric machine stator 102A, 102B (generally referred to as "102") and an electric machine housing 104A, 104B (generally referred to as "104"). The machine rotor 100 is rotatable about a rotational axis of the machine rotor 100, which rotational axis may also be an axial centerline of the electric machine 96. The machine stator 102 of FIG. 2 is radially outboard of and circumscribes the machine rotor 100. With this arrangement, each electric machine 96 is configured as a radial flux electric machine. The electric machines 96 of the present disclosure, however, are not limited to such an exemplary rotor-stator configuration nor to radial flux arrangements. The machine rotor 100, for example, may alternatively be radially outboard of and circumscribe the machine stator 102. In another example, the machine rotor 100 may be axially next to the machine stator 102 configuring the respective electric machine 96 as an axial flux electric machine. Referring again to FIG. 2, the machine rotor 100 and the machine stator 102 are at least partially or completely housed within the machine housing 104.

Each electric machine 96A, 96B may be operatively coupled to a respective one of the engine rotating structures 58A, 58B (generally referred to as "58"). Each machine rotor 100 of FIG. 2, for example, is mechanically coupled to and rotatable with the respective engine rotating structure 58 through a drivetrain 106A, 106B (generally referred to as "106"). This drivetrain 106 may be configured as or otherwise include a shaft, a tower shaft assembly, a gearbox, and/or the like. For ease of description, each machine rotor 100 of FIG. 2 is described below as being coupled to and rotatable with a unique one of the engine rotating structures 58 of the turbine engine 24. However, it is contemplated multiple machine rotors may alternatively be coupled to and rotatable with a common engine rotating structure 58. It is also contemplated a single one of the machine rotors may be coupled to and rotatable with multiple engine rotating structures, directly or through another device such as a differential or a clutch system. In addition, while the electric machines 96 are described above as being coupled to the engine rotating structures 58, it is contemplated the machine rotor 100 of one or more of the electric machines 96 may alternatively be operatively coupled to another rotating device through the drivetrain 106 such as, but not limited to, a pump rotor, an auxiliary compressor rotor, an actuator rotor, or the like.

Each electric machine 96 of FIG. 2 may be configurable as an electric motor and/or an electric generator; e.g., an electric motor-generator. For example, during a motor mode of operation, a respective electric machine 96 may operate as the electric motor to convert electricity received from the aircraft electrical system 94. The machine stator 102, for example, may generate an electromagnetic field with the machine rotor 100 using a current of electricity received from the aircraft electrical system 94 through the respective EM controller 98. This electromagnetic field may drive rotation of the machine rotor 100. The machine rotor 100, in turn, may provide mechanical power to and drive rotation of the respective engine rotating structure 58 through the respective drivetrain 106. This mechanical power may be provided to boost power or completely power the rotation of the respective engine rotating structure 58. By contrast, during a generator mode of operation, the electric machine 96 may operate as the electric generator to convert mechanical power received from the respective engine rotating structure 58 into electricity. Rotation of the machine rotor 100, for example, may be rotationally driven by rotation of the respective engine rotating structure 58 through the respective drivetrain 106. The rotation of the machine rotor 100 may generate an electromagnetic field with the machine stator 102, and the machine stator 102 may convert energy from the electromagnetic field into electricity. The respective electric machine 96 may then provide a current of electricity to the aircraft electrical system 94 through the respective EM controller 98 for storage and/or further use. The electric machines 96 of the present disclosure, however, are not limited to such exemplary operation. For example, one, some or all of the electric machines 96 may alternatively each be configured as a dedicated electric generator; e.g., without the electric motor functionality. One, some or all of the electric machines 96 may alternatively each be configured as a dedicated electric motor; e.g., without the electric generator functionality.

Each EM controller 98 includes a controller housing 108A, 108B (generally referred to as "108") and internal controller circuitry 110A, 110B (generally referred to as "110"). The controller housing 108 may be configured as an enclosed case (e.g., a closed or sealed container) for the respective controller circuitry 110. The controller circuitry 110 is disposed within an interior of the controller housing 108; e.g., an internal chamber or other volume(s) within and enclosed by the controller housing 108. The controller circuitry 110 includes various electrical components, connectors and the like. Examples of the electrical components include, but are not limited to, printed circuit board(s) (PCB(s)), electrical inductor(s), electrical inverter(s), electrical amplifier(s), electrical switch(es) (e.g., contactor(s), relay(s), etc.), a processing device, memory, a communication module, electrical transformer(s), electrical rectifier(s), and/or the like.

Each EM controller 98 is electrically coupled to a respective one of the electric machines 96 through one or more electric cables 112A, 112B (generally referred to as "112"); e.g., high voltage electric cables, power feeder cables, etc. More particularly, the controller circuitry 110 of each EM controller 98 is electrically coupled to the respective electric machine 96 and its machine stator 102 through the respective electric cables 112. Similarly, each EM controller 98 is electrically coupled to an electrical distribution bus 114 of the aircraft electrical system 94 through one or more electric cables 116A, 116B (generally referred to as "116"); e.g., high voltage electric cables, power feeder cables, etc. More particularly, the controller circuitry 110 of each EM controller 98 is electrically coupled to the aircraft electrical system 94 and its electrical distribution bus 114 through the respective electric cables 116.

Each EM controller 98 and its controller circuitry 110 are configured to control operation of a respective one of the electric machines 96. For example, when operating as the electric motor, the respective EM controller 98 and its controller circuitry 110 are configured to regulate a flow of electricity from the aircraft electrical system 94 to the respective electric machine 96. This electricity flow regulation may include: (a) turning-on the flow of electricity from the aircraft electrical system 94 to the respective electric machine 96 (e.g., electrically coupling the respective electric machine 96 to the aircraft electrical system 94); (b) turning-off the flow of electricity from the aircraft electrical system 94 to the respective electric machine 96 (e.g., electrically decoupling the respective electric machine 96 from the aircraft electrical system 94); (c) moderating the flow of electricity from the aircraft electrical system 94 to the respective electric machine 96. Here, the respective EM controller 98 operates as a motor controller. In another example, when operating as the electric generator, the respective EM controller 98 and its controller circuitry 110 are configured to regulate a flow of electricity from the respective electric machine 96 to the aircraft electrical system 94. This electricity flow regulation may include: (a) turning-on the flow of electricity from the respective electric machine 96 to the aircraft electrical system 94 (e.g., electrically coupling the respective electric machine 96 to the aircraft electrical system 94); (b) turning-off the flow of electricity from the respective electric machine 96 to the aircraft electrical system 94 (e.g., electrically decoupling the respective electric machine 96 from the aircraft electrical system 94); (c) moderating the flow of electricity from the respective electric machine 96 to the aircraft electrical system 94. Here, the respective EM controller 98 operates as a generator controller.

The aircraft electrical system 94 includes the electrical distribution bus 114. This aircraft electrical system 94 may also include a power source 118 and/or a power storage 120. The electrical distribution bus 114 is electrically coupled to each of the electric machines 96 through their respective EM controllers 98. The electrical distribution bus 114 is also electrically coupled to the power source 118 and the power storage 120. Of course, the electrical distribution bus 114 may also be electrically coupled to one or more additional electric components of the aircraft propulsion system 22 and/or one or more additional electric components of the aircraft outside of the aircraft propulsion system 22; e.g., airframe mounted electric components, etc. With this arrangement, the electrical distribution bus 114 provides an intermediate connection between the various electrical members (e.g., 98A, 98B, 118 and 120). The power source 118 may be an electric generator powered by the turbine engine 24 (see FIG. 1) or an electric generator powered by another aircraft powerplant; e.g., an engine of a companion aircraft propulsion system, an engine of an auxiliary power unit (APU), a fuel cell system, etc. The power storage 120 is configured to receive electricity from the electrical distribution bus 114 for storage. The power storage 120 is also configured to provide the stored electricity to the electrical distribution bus 114. The power storage 120, for example, may be configured as or otherwise include one or more electricity storage devices; e.g., batteries, super capacitors, etc. Of course, it is contemplated one of the electric machines 96 (e.g., operating as the electric generator) may also or alternatively operate as a power source for another one of the electric machines 96 (e.g., operating as the electric motor).

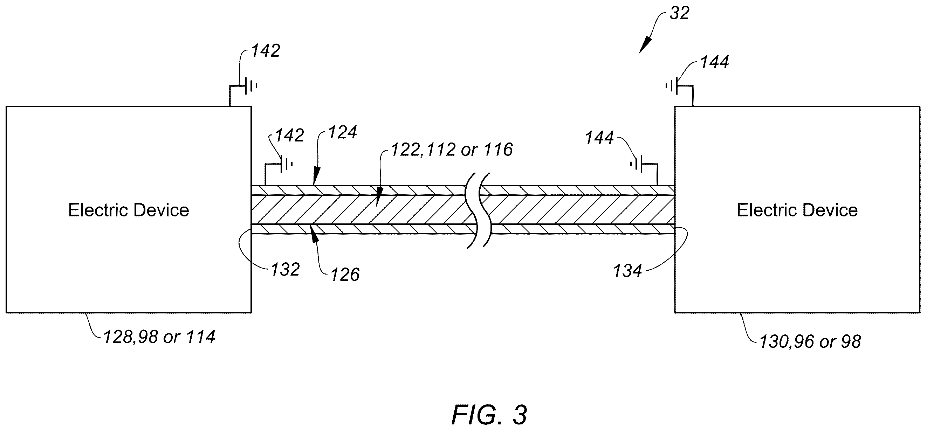

FIG. 3 illustrates an electric cable 122 arranged with a multi-function cable shield 124; e.g., a woven multi-material cable shield. For example, the electric cable 122 of FIG. 3 projects longitudinally through an internal bore 126 of the cable shield 124 as that electric cable 122 extends between a first electric device 128 and a second electric device 130. A first longitudinal end 132 of the cable shield 124 may be disposed at (e.g., on, adjacent or proximate) or otherwise arranged towards the first electric device 128. A second longitudinal end 134 of the cable shield 124 may be disposed at or otherwise arranged towards the second electric device 130. The cable shield 124 may thereby cover (e.g., extend longitudinally along and circumscribe) and shield a partial or entire longitudinal length of the respective electric cable 122 between the first electric device 128 and the second electric device 130. For ease of description, the electric cable 122 is described as an exemplary one of the electric cables 112 or 116 of FIG. 2, the first electric device 128 is described as one of the electric devices 98 or 114 of FIG. 2, and the second electric device 130 is described as one of the electric devices 96 or 98 of FIG. 2, respectively.

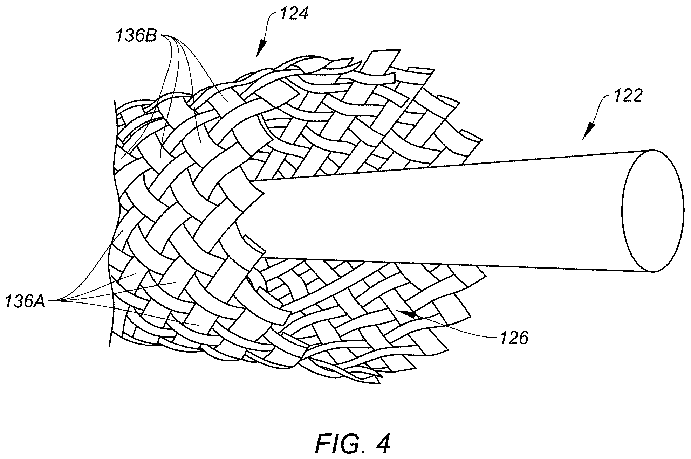

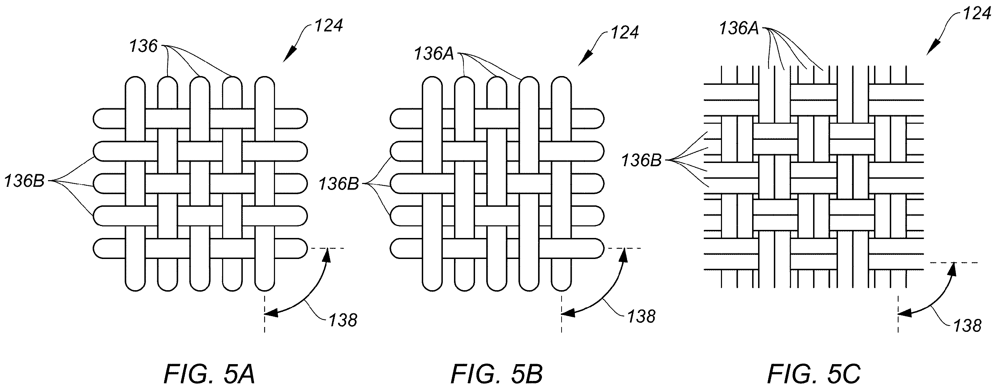

Referring to FIG. 4, the cable shield 124 includes a plurality of longitudinally elongated shield members 136A and 136B (generally referred to as "136"); e.g., filaments and/or filament sets. These shield members 136 are interwoven (e.g., braided) together into a woven tubular shield body; e.g., a braided cable sleeve. The shield members 136 may be woven together according to various patterns. Examples of these patterns include, but are not limited to, a plain weave pattern (e.g., see FIG. 5A), a twill weave pattern (e.g., see FIG. 5B) and a basket weave pattern (e.g., see FIG. 5C). Within each of the patterns, the shield members 136A, 136B are arranged into a plurality of groups where the shield members 136A, 136B in each group run substantially parallel with one another. By contrast, each shield member 136A in the first group is angularly offset from and crosses one, some or all of the shield members 136B in the second group, and vice versa. An offset angle 138 between (a) the first group and its first shield members 136A and (b) the second group and its second shield members 136B may be equal to or less than ninety degrees (90°); e.g., a right angle or a non-zero acute angle.

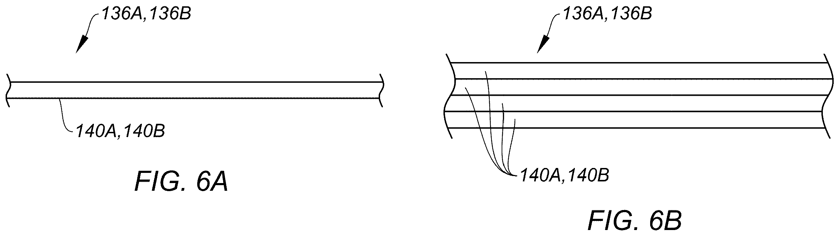

Referring to FIG. 6A, one, some or all of shield members 136 may each be configured as (e.g., only include) a single metal filament. For example, a first metal shield member may be configured as a single filament of a first metal - a first metal filament 140A. A second metal shield member may be configured as a single filament of a second metal - a second metal filament 140B. Referring to FIG. 6B, one, some or all of shield members 136 may alternatively each include a plurality of the metal filaments 140A, 140B (generally referred to as "140") grouped together into a filament set. In this filament set, the individual metal filaments 140 extend longitudinally side-by-side one another in parallel. Each of the metal filaments 140 in a respective filament set may be a common (the same) type of metal filament. For example, a first metal filament set may be formed by a grouping of (e.g., only) the first metal filaments 140A. In another example, a second metal filament set may be formed by a grouping of (e.g., only) the second metal filaments 140B. Alternatively, one or more of the first metal filaments 140A and one or more of the second metal filaments 140B may be grouped together into a common multi-metal filament set.

The first metal forming the first metal filaments 140A is selected to shield electromagnetic interference (EMI). This first metal may be a magnetic metal with a relatively high electromagnetic permeability. For example, the first metal may be, or include in an alloy, nickel (Ni), cobalt (Co) and/or iron (Fe) (e.g., a ferrous metal). More particularly, the first metal may be or otherwise include mu-metal. The present disclosure, however, is not limited to such exemplary high electromagnetic permeability metals. Here, the first metal has a higher electromagnetic permeability than the second metal.

The second metal forming the second metal filaments 140B is selected to facilitate electrical grounding. This second metal may be a non-magnetic metal with a relatively low electrical impedance. For example, the second metal may be, or include an alloy of, copper (Cu) and/or aluminum (Al). The present disclosure, however, is not limited to such exemplary low electrical impedance metals. Here, the second metal has a lower electrical impedance than the first metal.

Referring to FIG. 3, the electric cable 122 may conduct electricity with a relatively high current and/or a relatively high voltage between the respective electric devices 128 and 130 during operation of the electric machine system 32; see also FIG. 2. This flow of the electricity through the electric cable 122 between the respective electric devices 128 and 130 may generate and radiate electromagnetic interference; e.g., signal noise. Such electromagnetic interference may be disruptive to operation of other electronic equipment within the aircraft propulsion system 22. However, electromagnetic interference generated by and radiated from the electric cable 122 may be shielded and/or otherwise reduced by the relatively high electromagnetic permeability first metal in the cable shield 124 extending longitudinally along and circumscribing (via the first metal filaments 140A of FIG. 6A or 6B) the electric cable 122.

In addition to providing the electromagnetic interference shielding, the relatively low electrical impedance second metal in the cable shield 124 may facilitate electrical grounding for the electric machine system 32. The cable shield 124, for example, may be electrically ground with (or to) the first electric device 128 at the first longitudinal end 132 of the cable shield 124. The cable shield 124 may also or alternatively be electrically ground with (or to) the second electric device 130 at the second longitudinal end 134 of the cable shield 124. The cable shield 124 of FIG. 3 may thereby provide electrical grounding (via the second metal filaments 140B of FIG. 6A or 6B) between (a) a first structure 142 connected to and/or supporting the first electric device 128 and (b) a second structure 144 connected to and/or supporting the second electric device 130. The multi-metal cable shield 124 of the present disclosure may thereby provide multi-functions such as the above described electromagnetic interference shielding and electrical grounding.

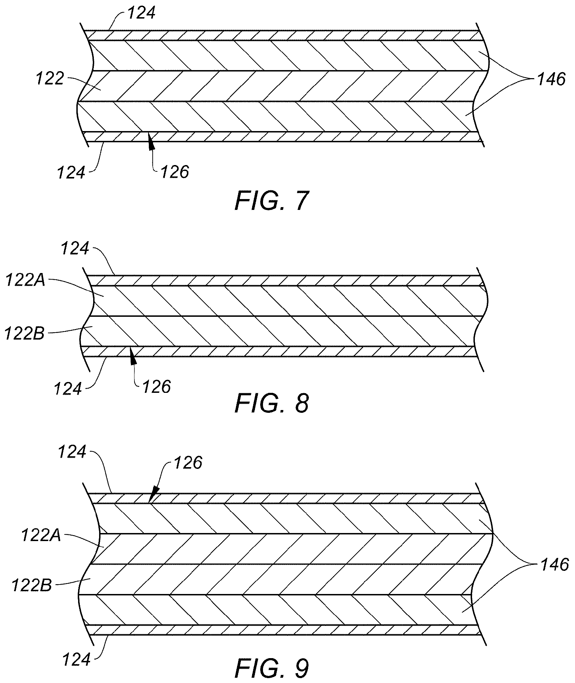

In some embodiments, referring to FIG. 7, insulation 146 may be disposed between the electric cable 122 and the surrounding cable shield 124. The insulation 146 of FIG. 7, for example, extends longitudinally along and circumscribes the electric cable 122. This insulation 146 also extends between and may contact the inner electric cable 122 and the surrounding cable shield 124. The cable shield 124 of FIG. 7 extends longitudinally along and circumscribes the insulation 146. The insulation 146 may be constructed from or otherwise include a fluoropolymer such as, but not limited to, perfluoroalkoxy alkane (PFA).

In some embodiments, referring to FIGS. 3 and 7, a single electric cable 122 may extend longitudinally through the bore 126 of each cable shield 124. The cable shield 124 may thereby be uniquely associated with a single one of the electric cables 122. In other embodiments, referring to FIGS. 8 and 9, multiple of the electric cables 122A and 122B (generally referred to as "122") may extend longitudinally through the bore 126 of a respective cable shield 124.

While the cable shield 124 is described above with respect to the electric machine system 32 of FIG. 2, the present disclosure is not limited to such an exemplary cable shield application. The cable shield 124, for example, may be used to provide electromagnetic interference shielding and/or electrical grounding for various other electrical devices, electrical systems within the aircraft. Moreover, it is contemplated the cable shield 124 of the present disclosure may provide electromagnetic interference shielding and/or electrical grounding for non-aircraft applications; e.g., ground-based electrical devices and/or electrical systems, water-based electrical devices and/or electrical systems, etc.

While various embodiments of the present disclosure have been described, it will be apparent to those of ordinary skill in the art that many more embodiments and implementations are possible within the scope of the disclosure. For example, the present disclosure as described herein includes several aspects and embodiments that include particular features. Although these features may be described individually, it is within the scope of the present disclosure that some or all of these features may be combined with any one of the aspects and remain within the scope of the disclosure. Accordingly, the present disclosure is not to be restricted except in light of the attached claims and their equivalents.

## Claims

1. An apparatus, comprising:
a first electric device (128);
a second electric device (130);
an electric cable (122) electrically coupling the first electric device (128) to the second electric device (130); and
a cable shield (124) comprising a first metal and a second metal, the first metal having a first permeability and a first impedance, the second metal having a second permeability and a second impedance, wherein the first permeability is greater than the second permeability, the first impedance is greater than the second impedance, and the electric cable (122) projects longitudinally, through a bore (126) of the cable shield (124) and along the first metal and the second metal, between the first electric device (128) and the second electric device (130).

2. The apparatus of claim 1, wherein the first metal is interwoven with the second metal longitudinally along the cable shield (124).

3. The apparatus of claim 1 or 2, wherein the cable shield (124) comprises a braided cable sleeve constructed from a plurality of filaments of the first metal and a plurality of filaments of the second metal.

4. The apparatus of claim 1, 2 or 3, wherein the cable shield (124) comprises a multi-filament set including:
a first filament of the first metal; and
a second filament of the second metal laterally next to and extending parallel with the first filament of the first metal.

5. The apparatus of claim 1, 2 or 3, wherein the cable shield (124) comprises:
a first filament of the first metal; and
a second filament of the second metal crossing the first filament of the first metal.

6. The apparatus of claim 1, 2 or 3, wherein the cable shield (124) comprises:
a first filament of the first metal; and
a second filament of the second metal angularly offset from the first filament of the first metal by an offset angle (138) equal to or less the ninety degrees.

7. The apparatus of any preceding claim, wherein:
the first metal is a mu-metal; and/or
the first metal comprises at least one of nickel, cobalt or iron; and/or
the first metal comprises a magnetic metal.

8. The apparatus of any preceding claim, wherein:
the second metal comprises at least one of copper or aluminum; and/or
the second metal comprises a non-magnetic metal.

9. The apparatus of any preceding claim, wherein the cable shield (124) is electrically grounded with at least one of the first electric device (128) or the second electric device (130).

10. The apparatus of any preceding claim, further comprising insulation (146) between the electric cable (122) and the cable shield (124).

11. The apparatus of any preceding claim, further comprising:
a second electric cable (122) electrically coupling the first electric device (128) to the second electric device (130), the second electric cable (122) projecting longitudinally, through the bore (126) of the cable shield (124) and along the first metal and the second metal, between the first electric device (128) and the second electric device (130); or
a second electric cable (122) electrically coupling the first electric device (128) to the second electric device (130), and a second cable shield (124) comprising the first metal and the second metal, wherein the second electric cable (122) projects longitudinally, through a bore (126) of the second cable shield (124) and along the first metal and the second metal, between the first electric device (128) and the second electric device (130).

12. The apparatus of any preceding claim, wherein:
the first electric device (128) comprises an electric machine (96A) configurable as at least one of an electric motor or an electric generator; and
the second electric device (130) comprises an electric machine controller (98A) for the electric machine,
wherein, optionally, the apparatus further comprises a rotating structure (58A) for an aircraft propulsion system (22), the rotating structure operatively coupled to the electric machine.

13. The apparatus of any of claims 1 to 11, further comprising:
an electric machine (96A) configurable as at least one of an electric motor or an electric generator;
the first electric device (128) comprising an electric machine controller (98A) for the electric machine (96A); and
the second electric device (130) part of an electrical system (94) for at least one of providing electrical power to or receiving electrical power from the electric machine (96A) controller.

14. An apparatus, comprising:
a first electric device (128);
a second electric device (130);
an electric cable (122) electrically coupling the first electric device (128) to the second electric device (130); and
a braided cable sleeve constructed from a plurality of filaments of a magnetic metal and a plurality of filaments a non-magnetic metal, wherein the electric cable (122) projects longitudinally, through a bore (126) of the braided cable sleeve and along the plurality of filaments of the magnetic metal and the plurality of filaments of the non-magnetic metal, between the first electric device (128) and the second electric device (130).

15. An apparatus, comprising:
a plurality of filaments woven together to form a braided cable sleeve with a bore (126) which extends longitudinally through the braided cable sleeve and along each of the plurality of filaments, the plurality of filaments comprising a plurality of magnetic metal filaments (140A) and a plurality of non-magnetic metal filaments (140B);
the plurality of magnetic metal filaments (140A) configured to provide electromagnetic interference shielding for an electrical cable (122) to be run longitudinally through the bore (126); and
the plurality of non-magnetic metal filaments (140B) configured to facilitate electrical grounding of the braided cable sleeve.
